# FASCICULE DE BREVET EUROPEEN

(11) **EP 2 575 205 B1**
(45) Date de publication et mention de la délivrance du brevet: **12.08.2015**
(21) Numéro de dépôt: 12290292.7
(22) Date de dépôt: 05.09.2012
(51) Int. Cl.: H01M 10/42, H01M 10/48, G01R 31/36, G01R 9/08

(54) **Procédé et système de diagnostic de l'état interne d'une batterie par émission acoustique**
Verfahren und System zur Diagnose des inneren Zustands einer Batterie durch Abgabe eines akustischen Signals
Method and system for diagnosing the internal state of a battery by acoustic emission

(30) Priorité: 30.09.2011 FR 1102983
(43) Date de publication de la demande: 03.04.2013
(73) Titulaire: IFP Energies nouvelles, 92852 Rueil-Malmaison Cedex (FR)
(72) Inventeur: Bernard, Julien, 69600 Oullins (FR)

(56) Documents cités:
- EP-A2- 0 957 560
- WO-A1-2011/001471
- DE-A1-102009 018 079
- FR-A1- 2 949 908
- JP-A- 7 006 795

## Description

### Domaine de l'invention

Le domaine général de l'invention est le diagnostic non intrusif de l'état interne des batteries.

L'invention concerne plus particulièrement l'utilisation de la technique d'émission acoustique pour le diagnostic de l'état interne de batteries.

### Art antérieur

La détermination de l'état de charge (SoC) et de l'état de santé (SoH) d'une batterie sont des critères essentiels pour caractériser l'état interne des éléments de stockage, afin d'optimiser la décharge/charge d'énergie, ainsi que la durée de vie des accumulateurs. Leurs connaissances sont d'autant plus critiques pour les batteries Li-ion, qu'une charge mal maîtrisée pour cette technologie peut conduire à l'emballement thermique de la cellule, voire à la destruction de l'accumulateur. Il est donc nécessaire de mettre au point une technique physique de mesure permettant la caractérisation de l'état interne, l'identification de défauts et le pronostic en service.

De nombreuses méthodes pour estimer l'état de charge (SoC) ont été proposées. Ces méthodes peuvent être regroupées en trois grandes familles :
- à partir d'une mesure physique en détectant un changement physique dans la batterie suivant la charge/décharge, par exemple par mesure de la densité de l'électrolyte au cours de la décharge. Cette méthode convient uniquement pour des batteries fixes pour lesquelles l'électrolyte intervient dans la réaction (par exemple des batteries au plomb).
- à partir des mesures de tension, de courant et de température. Une première méthode utilise le "coulomb-counting" : le courant entrant et sortant est mesuré et intégré pour connaitre la variation d'état de charge à partir d'un état connu. Ce procédé conduit cependant à des erreurs d'estimation en négligeant des phénomènes comme l'autodécharge. L'usage d'autres indicateurs, par exemple la tension à vide ou l'estimation d'une résistance interne (brevets US6191590 B1, EP1835297 A1) sont également connus. Dans ce type de procédés, le SoC est préalablement associé à une ou plusieurs quantités mesurables ou facilement estimables (potentiel, résistance interne, température), à travers des cartographies statiques ou des dépendances fonctionnelles analytiques. Ce type de procédé peut en particulier être utilisé pour recaler un procédé de type "coulomb-counting" pendant les phases d'arrêt. Pourtant, ces dépendances sont en réalité beaucoup plus compliquées que ce qui est normalement pris en compte dans le BMS, ce qui amène souvent à des erreurs dans l'estimation du SoC. Des méthodes plus complexes sont enfin basées sur un algorithme qui calcule en temps réel l'état de charge en utilisant en variables d'entrée le triptyque "tension - courant - température". Cette approche alternative se base sur des modèles mathématiques de batterie, afin d'utiliser des techniques d'estimation connues dans d'autres domaines. La demande de brevet US 2007/0035307 A1 décrit notamment une méthode pour estimer les variables d'état et les paramètres d'une batterie à partir des données de service (tension U, courant I, température T), utilisant un modèle mathématique de batteries. Le modèle mathématique est caractérisé par le fait qu'il comprend une pluralité de sous-modèles mathématiques, et permet une réponse plus rapide. Les sous-modèles sont des modèles de type circuit électrique équivalent, dit modèles RC, associés à des gammes de fréquences restreintes. Une autre méthode d'estimation du SoC connue dans la littérature ([Gu, White, etc.]) repose sur la description mathématique des réactions d'un système électrochimique. Le SoC est calculé à partir de variables d'état du système. Cette description s'appuie sur des bilans de matière, charge, énergie, ainsi que sur des corrélations semi-empiriques. Toutes ces méthodes sont utilisables dans des applications stationnaires ou embarquées comme dans les véhicules.
- à partir d'une sollicitation électrique envoyée à la batterie et en particulier la méthode de spectroscopie d'impédance électrochimique qui utilise une sollicitation électrique fréquentielle de faible amplitude : ces méthodes sont également utilisables pour estimer le SoH des batteries et sont décrites plus bas.

Concernant les méthodes d'estimation du SoH connues dans la littérature, on connait le document WO 2009/036444 dans lequel les auteurs introduisent une électrode de référence dans des éléments commerciaux afin d'observer les réactions de dégradation des électrodes. Cette méthode demande cependant une instrumentation importante, notamment pour insérer une électrode de référence à l'intérieur de l'élément, ainsi qu'une gestion électronique plus complexe de la batterie.

Le document FR2874701 décrit une méthode utilisant une perturbation électrique temporelle afin de comparer la réponse obtenue à une réponse de référence. Cependant, cette méthode est plus difficile à mettre en oeuvre pour des éléments type Li-ion dont les variations de réponse suite à ce type de perturbation sont très faibles, et donc ne peuvent donner lieu à une mesure de SoH précise.

Les estimations du SoC ou du SoH à partir de mesures d'impédance électrochimique sont multiples. La plus simple utilise des abaques préenregistrés à différents états de charge et différentes températures, de manière à remonter à l'état de charge à partir d'une mesure d'impédance en connaissant la température : cette méthodologie est largement pratiquée en laboratoire pour remonter à l'état interne, car en effet il y a des changements de l'impédance en fonction du SoC et du SoH.

Une méthode potentiellement plus prometteuse est basée sur la mesure par spectroscopie d'impédance (SIE) d'une grandeur paramétrée par le SoC. Par exemple, la demande de brevet US 2007/0090843 propose de déterminer par spectroscopie d'impédance la fréquence f± associée à la transition capacitive - inductive. Une corrélation entre la fréquence f± et le SoC est présentée pour une batterie au plomb, ainsi que pour les batteries Ni-Cd et Ni-MH. Une approche similaire est basée sur la modélisation des spectres SIE par circuits électriques équivalents, dont les composants sont paramétrés par le SoC, comme décrit dans le document US6778913 B2, qui permettent le développement d'un testeur de batteries automobiles Spectro CA-12 (Cadex Electronics Inc., Canada) basé sur la spectroscopie d'impédance électrochimique à multifréquences pour le couple acide-plomb. Les spectres SIE sont approchés par des circuits électriques équivalents, et l'évolution des composants est paramétrée par le SoC. De même, dans le document US 6037777, on détermine l'état de charge et autres propriétés de batteries par la mesure des parties réelles et imaginaires de l'impédance/admittance complexe pour des batteries au plomb ou d'autres systèmes. L'utilisation de modèles de type RC est décrite également dans le document EP880710, la description des phénomènes électrochimiques et physiques aux électrodes et dans l'électrolyte servant de support au développement du modèle RC, la température de la batterie étant simulée par le modèle, afin de gagner en précision, par rapport à une mesure externe.

Des analyses par impédance ont également été décrites dans la littérature. U. Tröltzsch et al (Electrochimica Acta 51, 2006, 1664-1672) décrivent une méthode dans laquelle ils utilisent la spectroscopie d'impédance, couplée à l'ajustement des impédances selon un modèle électrique pour obtenir l'état de santé de l'élément. Cette technique requiert cependant un arrêt de l'utilisation de l'élément pour la mesure.

La demande de brevet FR 2956486 de la demanderesse décrit une méthode de diagnostic de l'état interne d'une batterie comme le SOC ou le SOH au moyen de mesures d'impédance, modélisées au moyen d'un circuit équivalent. Une analyse statistique multivariée permet de calibrer une relation entre le Soc (et/ou le SoH) et les paramètres du circuit équivalent caractéristique d'une batterie donnée.

Cependant, les techniques de diagnostic classiques par mesure électrique comme la spectroscopie d'impédance demeurent des techniques complexes et longues à mettre en oeuvre. L'estimation de l'état interne d'une batterie est améliorée si l'on dispose d'un diagnostic complet : état de charge et état de santé, mais aussi état de défaillance d'un ou de plusieurs éléments de la batterie. A cet effet, il est nécessaire de disposer d'une technique non intrusive, permettant un diagnostic rapide de l'état interne, incluant l'anticipation d'une défaillance éventuelle, de la batterie.

La technique d'émission acoustique permet de détecter la défaillance d'une batterie, alors que cette défaillance n'est pas encore détectable par mesure électrique. Le principe d'utiliser l'émission acoustique pour étudier l'état physique des batteries ou de composants (par exemple les électrodes) a fait l'objet de travaux académiques concernant notamment l'étude des mécanismes d'insertion des ions durant la charge/décharge, mettant en évidence la sensibilité de la technique aux phénomènes d'insertion/désinsertion des ions dans les matériaux d'électrode de batterie Li-ion (par exemple Kalnaus, S., K. Rhodes, and C. Daniel. "A study of lithium ion intercalation induced fracture of silicon particles used as anode material in Li-ion battery." Journal of Power Sources In Press, Corrected Proof (2011)), mais aussi aux phénomènes de "broyage" électrochimique et mécanique des électrodes (par exemple Etiemble, A., H. Idrissi, and L. Roue. "On the decrepitation mechanism of MgNi and LaNi5-based electrodes studied by in situ acoustic emission." Journal of Power Sources 196.11 (2011): 5168-73.

Cependant, ces études ne visent pas à corréler l'état interne d'une batterie avec l'émission acoustique d'éléments de batterie durant des cyclages de charge et décharge.

Le brevet JP7006795A propose un dispositif permettant de détecter un signal d'émission acoustique issu d'une batterie, et de diviser ce signal en deux signaux en fonction de leur fréquence afin d'identifier la génération de gaz ou la détérioration de la structure interne de la batterie.

La demande de brevet WO11001471A décrit un dispositif pour détecter l'état interne d'une batterie, pouvant détecter au moyen de capteurs d'émission acoustique de petites ondes élastiques accompagnant une réaction à l'intérieur d'une batterie et pouvant vérifier avec précision les changements de l'état interne d'une batterie.

La demande de brevet FR2949908A décrit un procédé de surveillance d'un accumulateur électrochimique en charge ou en fonctionnement, qui comprend une étape de détection directe d'une anomalie au sein de l'accumulateur comme le déroulement d'au moins une réaction chimique néfaste au sein de l'accumulateur ou d'une dégradation physique de l'accumulateur.

Cependant, ces documents ne décrivent pas une méthode complète pour diagnostiquer avec précision un état interne donné d'une batterie, incluant la défectuosité et/ou l'état de charge et de santé de ladite batterie.

De manière surprenante, des essais ont montré que la technique d'émission acoustique pouvait non seulement permettre de suivre l'évolution de l'état interne de différentes batteries à travers l'enregistrement de signaux acoustiques produits lorsque les batteries fonctionnent, mais également de mettre en évidence une signature acoustique d'une défaillance ou d'un état interne donné de la batterie, par un traitement du signal réalisé sur les enregistrements de signaux. Au moyen d'une campagne d'essais comparatifs sur un ou plusieurs systèmes électrochimiques de référence, une relation entre un état interne donné et une signature acoustique peut être définie, permettant ultérieurement le diagnostic rapide et non intrusif sur un système électrochimique donné.

La méthode et le système selon l'invention permettent de déterminer l'état interne d'une batterie, notamment son état de santé (SOH pour "State Of Health"), son état de charge (SOC pour "State of Charge"), ou son état de défaillance ("failure state"), au moyen de la technique d'émission acoustique.

### Objets de l'invention

L'invention concerne un procédé d'estimation d'un état interne d'un premier système électrochimique de stockage d'énergie électrique, tel qu'une batterie, dans lequel on estime au moins une propriété relative à l'état interne dudit premier système électrochimique à partir d'une mesure d'émission acoustique.

L'invention concerne également un système d'estimation d'un état interne d'un système électrochimique de stockage d'énergie électrique.

L'invention concerne également un système intelligent de gestion d'une batterie (Battery Management System) comportant ledit système d'estimation d'un état interne de la batterie.

L'invention concerne également un véhicule comportant une batterie et un système intelligent de gestion d'une batterie selon l'invention.

L'invention concerne également un système de diagnostic d'une batterie comportant un système d'estimation d'un état interne de ladite batterie.

### Résumé de l'invention

L'invention concerne un procédé d'estimation d'un état interne d'un premier système électrochimique de stockage d'énergie électrique, tel qu'une batterie, dans lequel on estime au moins une propriété relative à l'état interne dudit premier système électrochimique à partir de mesures d'émission acoustique comportant les étapes suivantes :
- pour différents états internes d'au moins un second système électrochimique d'un même type que ledit premier système électrochimique : - on mesure une réponse d'émission acoustique dudit second système électrochimique correspondant à chaque état interne, et - on enregistre pour chaque réponse un signal caractéristique de ladite réponse d'émission acoustique dudit second système ;
- on réalise un traitement des signaux caractéristiques dudit second système enregistrés en les regroupant par populations de signaux ayant des paramètres communs ;
- on détermine une signature acoustique d'un état interne donné en calibrant une relation entre au moins un des paramètres communs à au moins une population de signaux acoustiques et un état interne donné dudit second système, au moyen d'une analyse des valeurs d'un ou plusieurs paramètres communs des populations de signaux acoustiques obtenues pour chacun desdits états internes ;
- on détermine une réponse d'émission acoustique dudit premier système électrochimique pour obtenir au moins un signal caractéristique de ladite réponse d'émission acoustique dudit premier système ;
- on estime l'état interne dudit premier système électrochimique grâce à ladite relation en détectant le ou les paramètre(s) caractéristiques de la signature acoustique d'un état interne donné, dans ledit signal caractéristique de ladite réponse d'émission acoustique dudit premier système.

De préférence, dans le procédé selon l'invention :
- on met au point un système permettant de détecter directement le ou le(s) paramètre(s) caractéristiques de la signature acoustique d'un état interne donné.

Dans un mode de réalisation, lesdits différents états internes sont obtenus en réalisant un vieillissement accéléré d'un second système électrochimique de stockage d'énergie électrique d'un même type que ledit premier système électrochimique.

Dans un autre mode de réalisation, lesdits différents états internes sont obtenus en sélectionnant un ensemble de seconds systèmes électrochimiques du même type que ledit premier système électrochimique, lesdits systèmes dudit ensemble ayant des états internes différents.

De préférence, on calcule au moins l'une des propriétés relatives à l'état interne dudit système électrochimique suivantes : un état de charge (SoC) dudit système, un état de santé (SoH) dudit système, un état de défaillance dudit système.

Le signal acoustique peut être défini par plusieurs paramètres choisis parmi les paramètres suivants : fréquence moyenne ou maximale, durée du signal, temps de montée du signal, nombre de coups du signal, amplitude du signal, énergie du signal ou toute combinaison de ces paramètres.

Dans un mode de réalisation, le système électrochimique est en fonctionnement.

Dans un autre mode de réalisation, le système électrochimique est au repos et un signal électrique est envoyé au système électrochimique pour le solliciter.

L'invention concerne un système d'estimation d'un état interne d'un système électrochimique de stockage d'énergie électrique, comportant :
- des moyens de mesure d'émission acoustique dudit système électrochimique comprenant un capteur (G) et un système d'acquisition relié à audit capteur (G);
- une mémoire permettant de stocker des paramètres des signaux acoustiques caractéristiques de l'état interne dudit système électrochimique et une signature acoustique sous forme d'une relation entre une propriété relative à l'état interne dudit système électrochimique et lesdits paramètres des signaux acoustiques caractéristiques de l'état interne dudit système électrochimique, ladite relation étant préalablement calibrée au moyen de mesures pour différents états internes d'au moins un second système électrochimique d'un même type que ledit système électrochimique ;

- des moyens de détection des paramètres caractéristiques de la signature acoustique d'un état interne donné dudit premier système électrochimique ;
- des moyens pour déterminer une propriété relative à l'état interne dudit système électrochimique au moyen de ladite relation.

De préférence, lesdits moyens de mesure d'émission acoustique comportent :
- au moins un capteur (piézo-électrique) en contact avec ledit système électrochimique ;
- un amplificateur permettant d'amplifier le signal acoustique ;
- un système d'acquisition permettant d'une part de filtrer les signaux acoustiques provenant de l'environnement extérieur et d'enregistrer les signaux acoustiques caractéristiques dudit système électrochimique.

Lesdits moyens de mesure d'émission acoustique peuvent comporter plusieurs capteurs permettant de détecter un état interne de plusieurs éléments qui composent un pack ou un module de batterie.

L'invention concerne également un système embarqué intelligent de gestion d'une batterie (*Battery Management System*) comportant un système d'estimation d'un état interne de ladite batterie tel que décrit ci-dessus.

L'invention concerne également un véhicule comportant une batterie et un système embarqué intelligent de gestion d'une batterie.

L'invention concerne également un système de diagnostic d'une batterie comportant un système d'estimation d'un état interne de ladite batterie tel que décrit ci-dessus.

Le système de diagnostic peut comporter en outre :
- un système de sollicitation en courant de ladite batterie.

### Description détaillée de l'invention

### Liste des figures

La figure 1 représente une salve d'émission acoustique et les paramètres d'émission acoustique (EA) calculés sur cette salve : amplitude (A), temps de montée (tm), durée (dm) entre deux dépassements (D1 et Dn) de seuil (L), nombre de coups (c).
La figure 2 représente le logigramme de la méthode selon l'invention.
La figure 3 représente la projection linéaire normée sur un plan (2D) de données acoustiques suivant les vecteurs propres normalisés V0 et V1.
La figure 4 représente le schéma de mise en place des capteurs d'émission acoustique placés sur un pack de batteries au plomb comrpenant 6 éléments (exemple).
La figure 5 représente les distributions de signaux acoustiques enregistrés sur les éléments 1 et 5 d'un pack de batteries au plomb selon l'exemple.
La figure 6 représente les diagrammes d'impédance selon la représentation de Nyquist de chacun des six éléments de la batterie au plomb de l'exemple.

### Description de la technique de l'émission acoustique

L'émission acoustique se définit comme *un phénomène de création d'ondes élastiques transitoires, résultant de micro-déplacements locaux internes à un matériau* (selon la norme ASTM E1316-05). Le terme *émission acoustique* désigne également la discipline qui utilise ce phénomène.

Une source d'émission acoustique est donc le lieu d'une dissipation d'énergie par brusque variation du champ de contrainte d'un matériau. Lors de cette variation, l'énergie est majoritairement dissipée sous forme d'onde élastique, le reste l'étant par dissipation thermique ou par déplacement de dislocations, qui peuvent créer à leur tour des ondes élastiques. Les ondes ainsi créées se déplacent au sein du matériau jusqu'à sa surface. Le signal mesuré par un capteur situé en surface du matériau est beaucoup plus faible que celui émis à la source. Il dépend fortement de la nature du phénomène émissif et de la nature du matériau, responsable en grande partie de son atténuation. Lorsqu'un matériau subit une sollicitation physique, chaque modification de structure interne devient source d'émission acoustique et donne naissance à des ondes élastiques transitoires qui se propagent au sein du matériau. La détection de ces signaux, appelés salves, permet donc de déceler en temps réel l'existence de ces évolutions. L'évaluation de l'importance de ces évolutions ainsi que leur nature peut être menée par l'analyse des paramètres acoustiques des salves émises. Une fois la contrainte passée, l'émission acoustique ne permet plus de déceler après coup l'évolution qu'a subie le matériau.

De nombreux phénomènes peuvent être à l'origine d'émission acoustique au sein d'un matériau.

On peut citer :
- déformation plastique, mouvement de dislocations, maclage, glissement aux joints de grains, formation de bande de Piobert-Lüders,
- ruptures d'inclusions ou de composés intermétalliques,
- transformation de phases (martensitique),
- amorçage et propagation de fissures (contraintes statiques, fatigues, etc.),
- fragilisation par hydrogène,
- corrosion localisée (corrosion sous contrainte, piqûre, crevasse),
- endommagement des matériaux composites et béton (micro-fissuration de la matrice, délaminage, ruptures d'interfaces, ruptures de fibres, etc.),
- frottement, impact mécanique.

Dans cette liste (non exhaustive) de phénomènes, on distingue plusieurs processus électrochimiques comme la dissolution du métal ou le dégagement de dihydrogène gazeux. Ainsi, la plupart des phénomènes électrochimiques advenant simultanément au sein d'un matériau constituant une électrode d'un système électrochimique quel qu'il soit (comme une batterie), peuvent être détectés et identifiés grâce à l'émission acoustique. Ainsi, couplée à une mesure électrochimique, l'émission acoustique permet d'obtenir des informations complémentaires à la mesure du courant et du potentiel et conduit en particulier à la discrimination des différents processus ayant lieu sur l'électrode.

### Instrumentation

La technique d'émission acoustique requiert une instrumentation spécifique permettant la mesure des ondes élastiques émises par un matériau. Un capteur est placé directement en contact avec la surface de l'échantillon étudié. Une salve créée par un micro-déplacement doit d'abord se propager dans le matériau avant d'arriver à sa surface. Le capteur enregistre les ondes mécaniques ainsi créées et les transforme en un signal électrique qui est pré-amplifié puis enregistré par un système d'acquisition.

Différents obstacles ou filtres naturels modifient nettement la nature et l'intensité des signaux lors de leur propagation, parmi lesquels le premier est le matériau lui-même. Le choix du capteur doit être adapté en fonction du type de source à étudier, des caractéristiques environnementales, de la sensibilité et en fonction du filtrage fréquentiel induit par la propagation dans le matériau.

Les capteurs les plus couramment utilisés en émission acoustique sont constitués d'une céramique piézo-électrique qui, lorsqu'elle est en contact avec le matériau, va convertir les ondes mécaniques en signaux électriques. La bonne transmission des ondes mécaniques entre le matériau et le capteur est en général assurée par l'intermédiaire d'un couplant acoustique telle qu'une graisse de silicone.

En sortie de capteur, les niveaux de tension générés sont très faibles ; c'est pourquoi il est nécessaire d'amplifier, éventuellement de filtrer en fréquence (filtre passe bande) et de conditionner le signal (adaptation d'impédance pour le transport du signal, parfois sur de longue distance) à l'aide d'un pré-amplificateur. Cette instrumentation spécifique minimise les perturbations induites par le milieu environnant.

Le système d'acquisition permet enfin la gestion de la configuration du système (paramètres d'acquisition, visuels type graphiques, de localisation), mais également l'analyse par extraction des caractéristiques d'émission acoustique lorsque la salve est numérisée. Le stockage des données est également assuré par le système d'acquisition.

### Paramètres d'émission acoustique

L'émission acoustique se fait par salves et donc de manière discontinue. Chaque salve possède des paramètres propres qui dépendent des phénomènes qui en sont à l'origine. L'acquisition numérique de ces salves permet de déterminer ces paramètres et ainsi de classer les événements enregistrés dans des familles qui correspondent chacune à un phénomène perturbateur au sein du matériau.

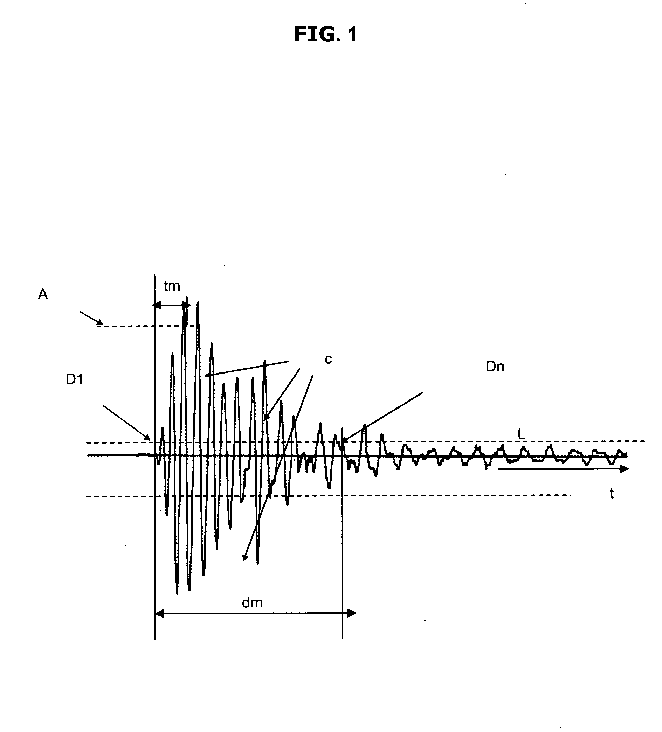

Une salve d'émission acoustique typique est représentée sur la figure 1 accompagnée des paramètres calculés par le système.

Avant toute mesure, il est nécessaire de définir un seuil de détection (en dB) en dessous duquel aucune salve ne sera mesurée par le système de détection. Il permet de définir le début d'une salve lors de son premier franchissement et ainsi le début des calculs pour les caractéristiques d'émission acoustique. Il est également nécessaire de définir des paramètres temporels afin de réaliser au mieux la mesure.

Les paramètres d'analyse extraits des salves numérisées peuvent être très nombreux et sont choisis par l'utilisateur. Une liste non exhaustive et non limitative de paramètres peut être définie comme suit (figure 1):
- amplitude maximale (A en dB): amplitude maximale du signal pendant toute la durée de la salve,
- temps de montée (tm en µs): intervalle de temps qui sépare le premier dépassement du seuil de l'instant où l'amplitude maximale est atteinte,
- durée (dm en µs): intervalle de temps entre le premier dépassement (D₁) et le dernier dépassement (Dₙ) de seuil de la salve,
- nombre de coups (sans dimension, c) : nombre de fois où l'amplitude du signal dépasse la valeur du seuil,
- énergie (énergie absolue ou énergie d'EA, 1 aJ = 10⁻¹⁸ J): l'intégrale du signal au carré sur la durée de la salve,
- fréquence au pic ou fréquence maximum (kHz): fréquence au maximum de la transformée de Fourier discrète de la salve,
- puissance partielle (kHz) : répartition d'énergie par bande de fréquences. Ce paramètre permet le réglage des bandes de fréquences pour caractériser la répartition énergétique spectrale de chaque salve. Les valeurs sont représentées en pourcentage de l'énergie totale de la salve. La densité spectrale d'énergie est toujours calculée à partir d'un kilo point extrait de la forme d'onde numérisée.

Il est ensuite possible de réaliser un traitement statistique de ces salves à l'aide de logiciels de traitement du signal. Cela permet de discriminer les différentes familles d'événements (populations) ayant des paramètres communs et ainsi de déterminer quels phénomènes ont lieu au sein d'un matériau, ainsi que leur durée et leur importance, lorsque ceux-ci sont clairement identifiés et corrélés à une famille d'événements.

### Principe général de la méthode

L'objet de l'invention concerne un procédé d'estimation d'un état interne d'un premier système électrochimique de stockage d'énergie électrique, tel qu'une batterie, dans lequel on estime au moins une propriété relative à l'état interne dudit premier système électrochimique à partir d'une mesure d'émission acoustique. Le procédé comporte les étapes suivantes :
- pour différents états internes d'au moins un second système électrochimique d'un même type que ledit premier système électrochimique : - on mesure les signaux d'émission acoustique correspondant aux différents états dudit second système en fonctionnement;
- on identifie parmi les différentes populations de signaux acoustiques au moins une population directement issue de l'état interne que l'on cherche à estimer;
- on identifie au moins un paramètre des signaux acoustiques de cette population qui se distingue de tous les autres paramètres des autres signaux acoustiques mesurés; les paramètres des signaux acoustiques sont du type fréquence moyenne ou maximale, durée du signal, temps de montée du signal, nombre de coup du signal, amplitude du signal, énergie du signal, etc..., mais tout autre paramètre ou toute combinaison de paramètres peuvent être utilisés pour déterminer la signature acoustique d'un état interne donné.
- on estime l'état interne dudit premier système électrochimique en détectant le ou les paramètres acoustiques relatifs à l'état interne dudit système électrochimique.

Selon l'invention, les différents états internes peuvent être obtenus en faisant varier l'état de charge et/ou en réalisant un vieillissement accéléré d'un second système électrochimique de stockage d'énergie électrique d'un même type que le premier système électrochimique. Les différents états internes peuvent également être obtenus en sélectionnant un ensemble de seconds systèmes électrochimiques du même type que le premier système électrochimique, les systèmes de l'ensemble ayant des états internes différents.

On peut mesurer au moins l'une des propriétés relatives à l'état interne du système électrochimique suivantes : un état de charge (SoC) du système, un état de santé (SoH) du système ou un état défaillant du système, dans la mesure ou un de ces état entraine la création de signaux acoustiques dont au moins un paramètre se distingue des paramètres des autres signaux acoustiques générés par le système.

Selon l'invention, le système électrochimique peut être en fonctionnement ou à l'arrêt. Dans ce dernier cas, un signal électrique est envoyé à la batterie pour la solliciter. Ce signal peut être le courant envoyé pendant la charge de la batterie ou un signal électrique à façon tel qu'un pulse de courant ou de tension.

L'invention concerne également un système d'estimation d'un état interne d'un système électrochimique de stockage d'énergie électrique, comportant :
- des moyens de mesure d'émission acoustique (G) incluant un capteur d'émission acoustique relié à un système d'acquisition ;
- des moyens pour calculer les paramètres des signaux acoustiques mesurés;
- une mémoire permettant de stocker les paramètres des signaux caractéristiques de l'état interne dudit système électrochimique;
- des moyens pour mettre en relation les paramètres des signaux acoustiques calculés avec les paramètres à l'état interne dudit système électrochimique.

Selon l'invention le moyen de mesure d'émission acoustique comporte :
- un capteur piézoélectrique permettant lorsqu'il est mis en contact sur le système électrochimique de détecter des ondes élastiques se propageant au sein dudit système; Ce capteur peut être mis en contact de manière permanente sur la système électrochimique ou de manière ponctuelle. Le contact entre le capteur et la surface du système électrochimique doit être fait avec un bon couplage acoustique. Le capteur peut être collé, fixé ou attaché en maintenant une pression entre le capteur et la surface du système électrochimique. De la graisse de contact permettant un bon couplage acoustique peut également être utilisée.
- un amplificateur permettant d'amplifier le signal acoustique
- un système d'acquisition permettant d'une part de filtrer les signaux acoustiques provenant de l'environnement extérieur et dont les paramètres sont très différents de ceux générés par le système électrochimique, et d'autre part d'enregistrer les signaux acoustiques.

L'invention concerne également un système intelligent de gestion d'une batterie (Battery Management System) comportant un système d'estimation d'un état interne de la batterie selon l'invention, et un véhicule comportant une batterie et un système intelligent de gestion d'une batterie selon l'invention.

L'invention concerne également tout autre système de stockage d'énergie électrique comportant un système d'estimation de son état interne selon l'invention, par exemple un système photovoltaïque de stockage d'énergie électrique, ou tout autre système de stockage d'énergie électrique, notamment dans le domaine de l'électronique portable.

L'invention concerne également un système composé de plusieurs capteurs permettant de détecter un état interne de plusieurs éléments qui composent un pack ou un module de batterie. En particulier l'invention concerne également un système composé de plusieurs capteurs placé sur chacun des élément d'une batterie pour laquelle l'accès à des informations au niveau des éléments est impossible (par exemple une batterie au plomb scellée). Dans ce cas l'invention peut également permettre de détecter l'apparition d'une divergence ou d'une défaillance d'un des éléments constitutifs du pack alors que cette divergence ou défaillance n'est pas détectable par la mesure globale des signaux électriques globaux du pack batterie.

L'invention concerne également un système capable de détecter un paramètre représentatif d'un état interne donné, dans le cas ou ce paramètre peut être détecté sans étape de traitement du signal. Par exemple dans le cas où la signature acoustique d'une population est une énergie de salve élevée (et supérieure à l'énergie des autres salves), un système capable de détecter le dépassement d'un seuil d'énergie de salve de référence permettrait de détecter l'état interne du système correspondant, l'énergie haute étant une signature acoustique suffisante de l'état.

### Logigramme de la méthode

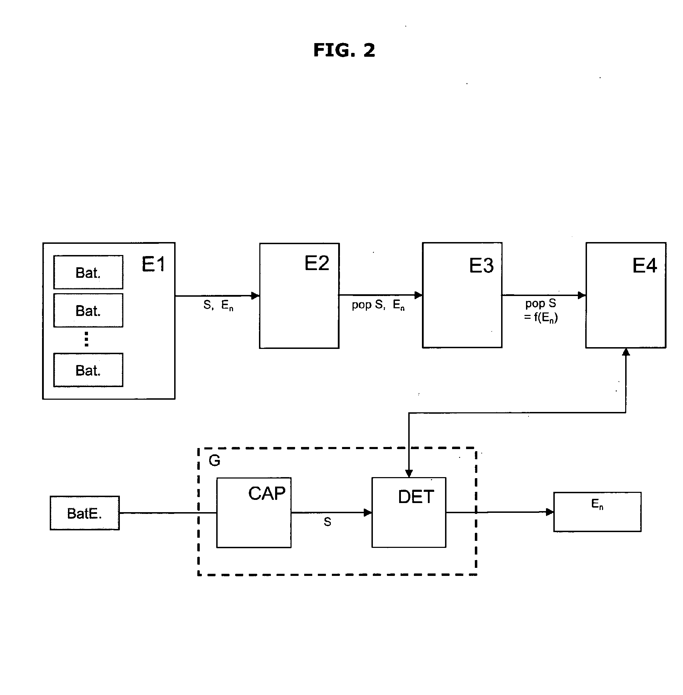

Le logigramme de la méthode est représenté sur la figure 2. La méthode selon l'invention comporte les étapes suivantes :
Étape E1 : on réalise une campagne d'essais en laboratoire sur un lot de batteries (Bat.) afin de mesurer les signaux acoustiques produits par les batteries lorsque celles-ci sont sollicitées (en fonctionnement, charge, décharge, pulse de courant, etc...) et ce en fonction du SoC, du SoH, de l'état de fonctionnement (défaillance ou non) et de la température sur la plage de température de fonctionnement usuel des batteries. On obtient des signaux d'émission acoustique (S) correspondant aux n états (E).
Étape E2 : on réalise un traitement des signaux enregistrés en commençant d'une part par les regrouper par population de signaux (pop S), chaque population ayant des paramètres communs. Les paramètres des signaux acoustiques sont du type : fréquence moyenne ou maximale, durée du signal, temps de montée du signal, nombre de coup du signal, amplitude du signal, énergie du signal, etc... On obtient des populations de signaux pour n états.
Étape E3 : on attribue une population d'événements pop S à un état E du système. Par exemple une population d'événements acoustiques peut être présente uniquement sur une plage de SOC, elle sera donc le signe que la batterie fonctionne dans cette plage. Une population d'évènements peut également apparaître à partir d'un certain stade de vieillissement, et constituer la signature acoustique de l'atteinte de ce stade de vieillissement. Enfin, une population d'évènements peut apparaître lorsqu'un phénomène irréversible de dégradation entraînant une défaillance apparaît, et ainsi constituer la signature acoustique du début de la défaillance d'une batterie.
Étape E4 : Parmi les populations qui correspondent à des états internes qui intéressent l'utilisateur, on cherche à identifier les paramètres des signaux ou les combinaisons de paramètres des signaux qui se distinguent des paramètres des autres signaux. Par exemple une population d'évènements qui correspond à un phénomène de défaillance peut avoir une énergie supérieure à l'énergie de tous les autres signaux. Ou encore, la fréquence des signaux correspondant à l'apparition de la pleine charge d'une batterie aqueuse peut être distincte des fréquences des autres signaux.

Dans un second temps on réalise le système G capable de détecter sur une batterie (BatE) l'état interne recherché. Ce système est composé d'une part d'un capteur d'émission acoustique et son système d'acquisition (CAP), et d'autre part d'un dispositif (DET) capable de détecter la signature acoustique de la population correspondant à l'état du système recherché, en identifiant le ou les paramètres caractéristiques correspondant à cette population et identifiés dans les étapes E1 à E4.

Sous sollicitations, que ce soit en fonctionnement normal, en charge ou selon des profils de courant ou de tension spécifiques, la batterie BatE émet des signaux acoustiques. Le dispositif G mesure et traite ces signaux de manière à détecter la signature acoustique du ou des états internes de la batterie recherchés et renvoyer cet état à l'utilisateur.

### Détermination de la signature acoustique correspondant à un état interne (SOC, SOH, état de défaillance) donné

Dans un premier temps, une campagne d'essais en laboratoire permet de mesurer les signaux d'émission acoustique se produisant sur une batterie en fonction de son SoC, de son SoH, de son état de défaillance ou non et éventuellement de la température. De façon générale, pour différents états internes d'au moins un second système électrochimique d'un même type que le système électrochimique qui intéresse l'utilisateur : - on mesure la propriété relative (SoC, SoH, état de défaillance) à l'état interne du second système; et - on mesure la réponse d'émission acoustique de ce second système électrochimique lorsque celui-ci est sollicité autour de l'état interne en question.

Selon un mode de réalisation, pour un type de batterie (BatE.) donné, et pour une application de cette batterie donnée, on utilise une batterie du même type (Bat.). Puis, on réalise des mesures de réponses d'émission acoustique pour différents états de charge, santé et défaillance de cette batterie. Pour obtenir des états de santé différents de cette batterie, on peut réaliser un vieillissement accéléré représentatif de l'application visée. Par exemple, la batterie subit en laboratoire un protocole de vieillissement accéléré simulant une application embarquée de type véhicule hybride ou un protocole de vieillissement accéléré simulant toute autre application pour laquelle le système de stockage d'énergie est utilisée. Le vieillissement peut être prolongé jusqu'à obtenir un mode défaillant en particulier.

La mesure des signaux acoustiques peut être obtenue par application d'une perturbation en courant ou en tension au borne de la batterie de manière à ce que celle-ci ne soit pas au repos (sinon les signaux acoustiques sont inexistants ou très peu présents). La mesure des signaux acoustiques se fait à l'aide d'un moyen de mesure utilisant un capteur d'émission acoustique placé en contact de la batterie.

La mesure des signaux acoustiques en fonction du SoC peut être faite sur la pleine plage de SoC ou uniquement sur la plage de SoC correspondant à celle utilisée pour l'application.

L'évolution des signaux acoustiques avec la température sur la plage de température de fonctionnement de l'application est également mesurée.

A chaque état de charge et/ou de vieillissement, la mesure des signaux acoustiques du système électrochimique est mesurée par application d'une perturbation en courant au moyen d'un galvanostat. Cette mesure peut se faire en continu au cours d'une charge ou décharge complète d'une batterie.

On peut utiliser pour la calibration une seconde batterie de même type que la batterie étudiée ; on peut également utiliser un ensemble de batteries du même type, chacune de ces batteries possédant un état de charge et/ou un état de santé différent.

### Traitement des signaux acoustiques

Il s'agit de réaliser un traitement statistique de l'ensemble des salves acoustiques enregistrées. Des logiciels et des méthodes classiques de traitement du signal peuvent être utilisées. L'objectif est de discriminer les différentes familles d'événements ayant des paramètres communs et ainsi de pouvoir corréler une ou plusieurs de ces familles à des états internes particuliers du système étudié, et éventuellement leur durée et leur importance, lorsque ceux-ci sont clairement identifiés et corrélés à une famille d'événements.

Lorsque les populations d'événements acoustiques présentent des répartitions simples, il est possible de les discriminer en représentant ces populations selon des axes à deux dimensions, les deux dimensions étant des paramètres acoustiques (par exemple la fréquence des salves acoustiques en fonction de leur amplitude). Ce traitement simple peut permettre de faire apparaitre des ensembles d'évènements regroupés en populations de paramètres proches.

Dans le cas ou les populations présentent des répartitions complexes, une analyse en composantes principales peut être effectuée. Chaque signal d'émission acoustique est représenté dans un espace multidimensionnel par un vecteur, dont les coordonnées sont les différents paramètres acoustiques. Par exemple, un signal acoustique peut-être défini par un vecteur de type :
S = f (amplitude, énergie, nombre de coups, durée, temps de montée, etc.)

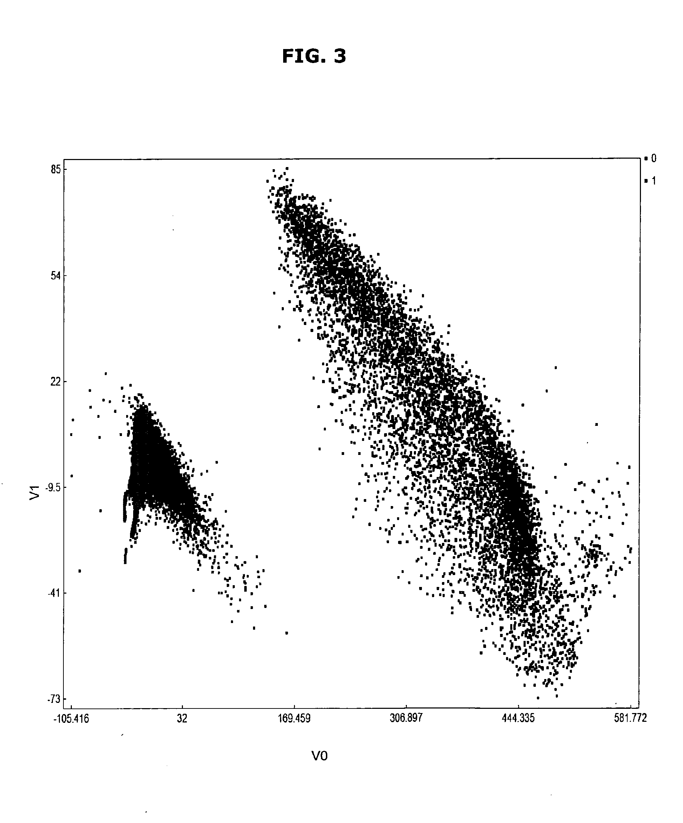

La séparation de l'ensemble de ces vecteurs en plusieurs populations d'événements peut ensuite s'effectuer de la manière suivante :
- suppression des paramètres ne donnant aucune information sur la nature physique des signaux d'EA, tels que le seuil et le canal d'acquisition,
- suppression des paramètres corrélés lorsque l'information d'un seul parmi plusieurs paramètres est suffisante.
- projection en vecteurs propres normalisés : la projection linéaire normée sur un plan (2D) de paramètres non corrélés rend le système adimensionnel et permet de maximiser la dispersion des vecteurs. La dimension du réseau de données correspond au nombre de paramètres projetés. Ainsi, 2 vecteurs ayant des caractéristiques proches sont représentés dans la même région de l'espace. Par exemple, la figure 3 représente une projection de données acoustiques suivant les vecteurs propres normalisés V0 et V1.

La séparation de l'ensemble des signaux d'EA en plusieurs classes peut être réalisée à partir d'un traitement statistique. Il existe différentes méthodes de classification comme l'utilisation d'un algorithme itératif simple (K-means), lequel tend à minimiser l'écart au carré entre chaque point pour un nombre de populations donné.

Lorsqu'une population d'événements est déterminée de manière claire par le logiciel utilisé, elle peut être supprimée du fichier et le traitement statistique repris sur la partie restante.

### Avantages de la méthode

La technique peut donc constituer une solution alternative ou complémentaire aux techniques de diagnostic classiques par mesure électrique comme la spectroscopie d'impédance qui n'est que peu exploitée aujourd'hui du fait de sa complexité. L'intérêt de cette technique réside principalement dans le caractère non intrusif puisqu'il suffit de placer et maintenir un/des capteurs à la surface des éléments d'un pack batterie. Le diagnostic peut également être très rapide (dans le cas d'une défaillance en particulier) et peut permettre d'anticiper une défaillance (les mécanismes de dégradation produisant souvent des phénomènes acoustiques très tôt, bien avant que ceux-ci influent sur des paramètres mesurables par des mesures électriques).

En particulier la technique permet de détecter la défaillance d'une batterie, alors que cette défaillance n'est pas encore détectable par mesure électrique. En particulier, cette technique permet également de détecter un élément défaillant parmi plusieurs éléments d'un pack batterie scellé pour lequel l'accès à des informations à l'échelle d'un élément unitaire n'est pas possible.

L'intérêt résultant est un gain de temps et d'énergie, en évitant d'effectuer une recharge sur une batterie qui est hors d'usage. En cas d'endommagement réversible (comme la sulfatation des batteries au plomb par exemple), la méthode peut aussi permettre de vérifier si l'opération de régénération a été efficace.

### Applications du procédé selon l'invention

Le procédé selon l'invention permet de réaliser une jauge de l'état interne comme l'état de charge, l'état de santé ou l'état défaillant d'une batterie préalablement identifiée pour une utilisation donnée, par exemple dans une application transport (batterie de traction), pour le stockage des énergies renouvelables ou tout autre application utilisant des systèmes de stockage de l'énergie électrique. Le principe proposé consolide les estimations faites par le système de gestion de la batterie, ces données n'étant pas mesurables directement.

### Véhicules hybrides ou électriques

Le procédé peut être embarqué dans un véhicule hybride ou électrique et permet de déterminer un état interne d'une batterie à partir d'une ou plusieurs mesures d'émission acoustique.

Les mesures d'émission acoustique sont effectuées à partir de capteurs placés directement à la surface d'un ou de plusieurs éléments de batteries, ou indirectement via un guide d'ondes permettant de transmettre des ondes élastiques. Le procédé peut être utilisé en complément des procédés classiques d'estimation mis en oeuvre par le BMS. Le procédé peut être directement intégré au BMS.

Dans le domaine automobile, cette technique peut également être utilisée pour le diagnostic de batteries des véhicules électriques ou hybrides chez le concessionnaire lors de contrôles. Les capteurs peuvent être placés sur les éléments de batterie par le technicien effectuant le contrôle. Les capteurs peuvent également avoir déjà été mis en place lors de la fabrication de la batterie en prévision des contrôles.

Lors du contrôle le système peut être placé sous sollicitations spécifiques (pulses de courants par exemple) par le concessionnaire ou le contrôle effectué pendant la charge des véhicules, voire en ligne lorsque le véhicule fonctionne.

Un kit de diagnostic externe comprend le système d'estimation de l'état interne de batterie selon l'invention. Un tel kit peut également comprendre un système de sollicitation en courant de la batterie pour éviter au concessionnaire de mettre le véhicule en charge ou de démarrer le véhicule.

### Défaillance de batteries

La méthode selon l'invention peut également être utilisée pour le diagnostic de défaillance d'un ou de plusieurs éléments d'un pack de batteries à travers un système multicapteurs capable de détecter des signaux acoustiques caractéristiques d'une dégradation. Le diagnostic permet ainsi de détecter les éléments défaillants d'un pack afin de les remplacer lorsque ceux-ci sont démontables. Il permet également de détecter qu'un pack est hors service lorsqu'au moins un des éléments du pack est défaillant et que ces éléments ne sont pas démontables.

### Autres

Le procédé d'estimation de l'état interne selon l'invention peut être utilisé dans tout type système de stockage d'énergie, notamment un système de stockage de l'énergie photovoltaïque ou dans le domaine de l'électronique portable.

L'invention s'applique avantageusement dans le cas des batteries au plomb, comme en témoigne l'exemple ci-dessous.

### Exemple : essais réalisés sur batteries au plomb

Une batterie au plomb de démarrage composée de 6 éléments indissociables a été récupérée chez un concessionnaire. Cette batterie avait déjà servie et possédait des performances faibles (difficulté à charger).

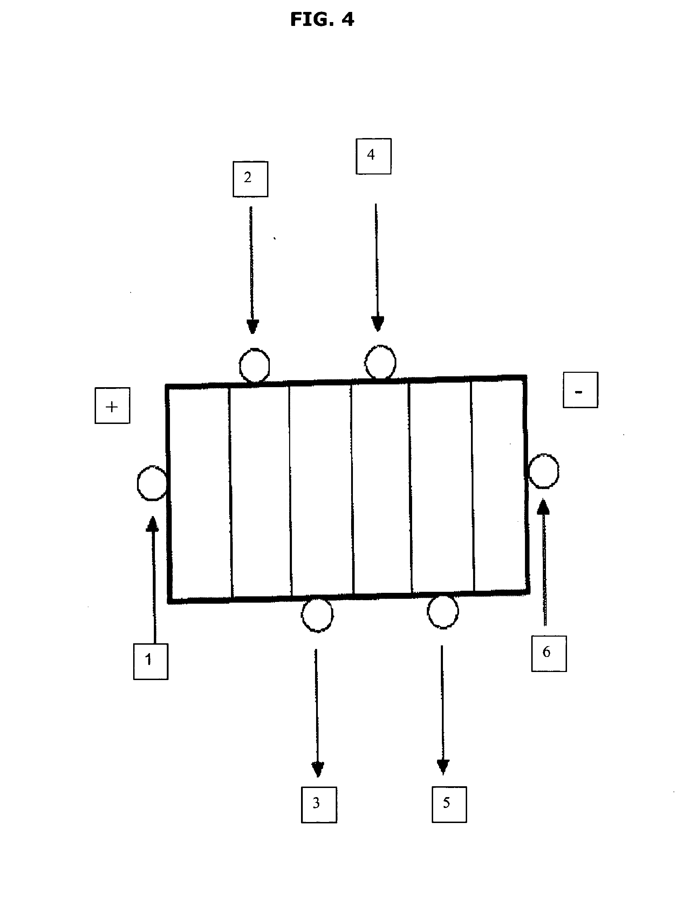

Six capteurs d'émission acoustique ont été placés sur cette batterie, un par élément selon le schéma de la figure 4.

La batterie a ensuite été mise en charge et les signaux d'émission acoustiques de chacun des six éléments enregistrés pendant la charge à travers les six capteurs.

L'ensemble des signaux acoustiques enregistrés sur chacun des capteurs pendant la charge a ensuite été traité selon des techniques d'analyse décrites plus haut. La projection des vecteurs signaux selon certaines dimensions a permis de faire apparaître une population de signaux de haute énergie sur l'élément 5, cette population d'évènements n'étant pas présente sur les autres éléments.

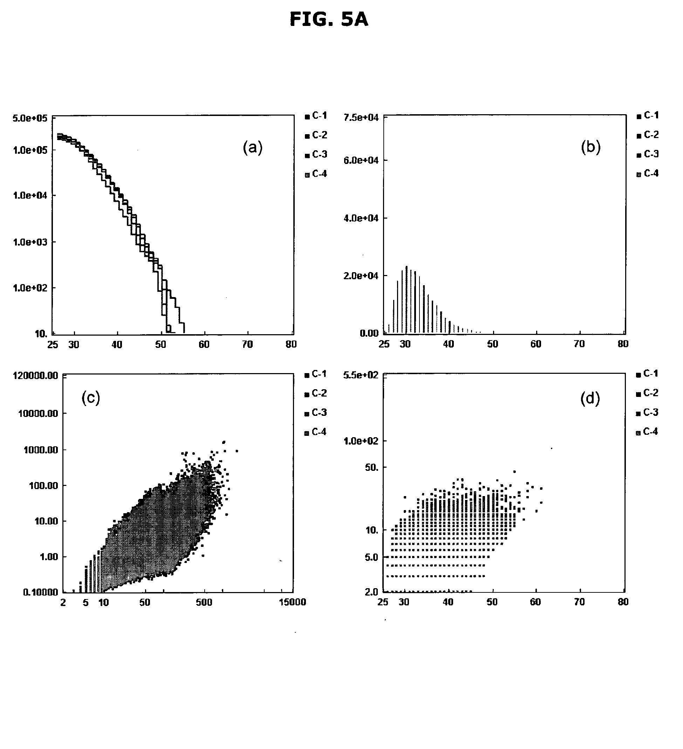

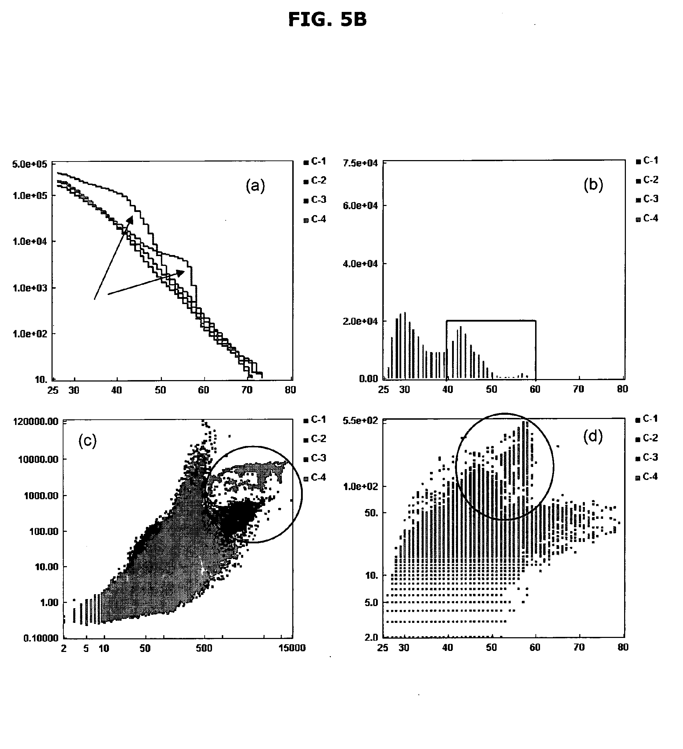

A titre d'exemple, les distributions des signaux enregistrés sur les éléments 1 et 5 sont présentés respectivement sur les figures 5A et 5B.

Les figures 5Aa) et 5Ba) montrent la distribution du nombre de signaux d'émission acoustique en fonction de l'amplitude (mode cumulé - pente de Pollock).

Les figures 5Ab) et 5Bb) montrent la distribution du nombre de signaux d'émission acoustique en fonction de l'amplitude.

Les figures 5Ac) et 5Bc) montrent la corrélation entre l'énergie et l'amplitude.

Les figures 5Ad) et 5Bd) montrent la corrélation entre le nombre de coups et l'amplitude.

La comparaison entre les figures 5A et 5B montrent que l'élément 5 fait apparaître une population d'évènements acoustiques d'énergie importante qui n'apparaît pas sur les autres éléments (voir signaux entourés ou encadrés sur la figure 5B).

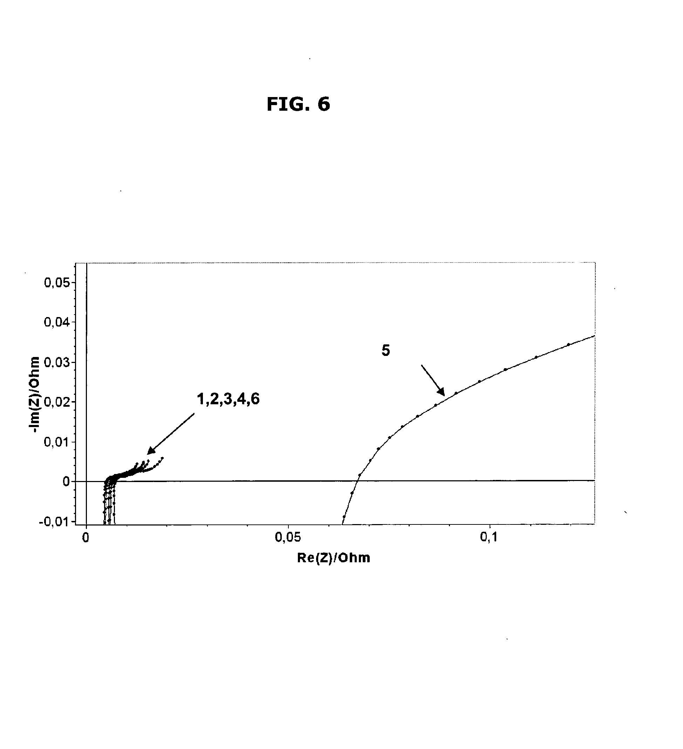

Afin d'attribuer cette population d'évènements à un état du système, la batterie a été démontée et le diagramme d'impédance de chacun des six éléments a été mesuré par la technique de spectroscopie d'impédance électrochimique. En haute fréquence (partie des diagrammes qui coupe l'axe des abscisses) l'impédance mesurée sur les éléments 1, 2, 3, 4 et 6 est de l'ordre de 5 à 7 mOhms, ce qui est une valeur normale (figure 6). L'impédance haute fréquence mesurée sur l'élément n°5 est de l'ordre de 65 mOhms soit une valeur 10 fois supérieure, signe d'une défaillance confirmée de cet élément.

La population d'évènements acoustiques d'énergie importante constitue donc la signature acoustique de la défaillance de l'élément 5.

En mettant ensuite au point un capteur basé sur la technique d'émission acoustique permettant d'identifier la population d'évènements supplémentaires définie sur la figure 5, il est donc possible de déterminer l'état de défaillance d'un élément de pack de batterie au plomb et donc l'état de défaillance du système complet, celui-ci n'étant pas démontable de manière réversible.

## Revendications

1. Procédé d'estimation d'un état interne d'un premier système électrochimique de stockage d'énergie électrique, tel qu'une batterie, dans lequel on estime au moins une propriété relative à l'état interne dudit premier système électrochimique à partir de mesures d'émission acoustique comportant les étapes suivantes :
- pour différents états internes d'au moins un second système électrochimique d'un même type que ledit premier système électrochimique : - on mesure une réponse d'émission acoustique dudit second système électrochimique correspondant à chaque état interne, et - on enregistre pour chaque réponse un signal caractéristique de ladite réponse d'émission acoustique dudit second système ;
- on réalise un traitement des signaux caractéristiques dudit second système enregistrés en les regroupant par populations de signaux ayant des paramètres communs ;
- on détermine une signature acoustique d'un état interne donné en calibrant une relation entre au moins un des paramètres communs à au moins une population de signaux acoustiques et un état interne donné dudit second système, au moyen d'une analyse des valeurs d'un ou plusieurs paramètres communs des populations de signaux acoustiques obtenues pour chacun desdits états internes ;
- on détermine une réponse d'émission acoustique dudit premier système électrochimique pour obtenir au moins un signal caractéristique de ladite réponse d'émission acoustique dudit premier système ;
- on estime l'état interne dudit premier système électrochimique grâce à ladite relation en détectant le ou les paramètre(s) caractéristiques de la signature acoustique d'un état interne donné, dans ledit signal caractéristique de ladite réponse d'émission acoustique dudit premier système.

2. Procédé selon la revendication 1 dans lequel :
- on met au point un système permettant de détecter directement le ou le(s) paramètre(s) caractéristiques de la signature acoustique d'un état interne donné, ledit système comprenant :
• un capteur d'émission acoustique et un système d'acqusition de l'émission acoustique pour déterminer une réponse d'émission acoustique du premier système électrochimique et pour obtenir au moins un signal caractéristique de ladite réponse ; et
• un dispositif d'identification du ou des paramètre(s) caractéristiques d'une population de signaux identifiée lors du traitement des signaux du second système électrochimique pour détecter la signature acoustique d'un état interne donné dans le signal caractéristique de la réponse d'émission acoustique du premier système électrochimique.

3. Procédé selon la revendication 1 ou 2, dans lequel lesdits différents états internes sont obtenus en réalisant un vieillissement accéléré d'un second système électrochimique de stockage d'énergie électrique d'un même type que ledit premier système électrochimique.

4. Procédé selon la revendication 1 à 3, dans lequel lesdits différents états internes sont obtenus en sélectionnant un ensemble de seconds systèmes électrochimiques du même type que ledit premier système électrochimique, lesdits systèmes dudit ensemble ayant des états internes différents.

5. Procédé selon l'une des revendications précédentes, dans lequel on calcule au moins l'une des propriétés relatives à l'état interne dudit système électrochimique suivantes : un état de charge (SoC) dudit système, un état de santé (SoH) dudit système, un état de défaillance dudit système.

6. Procédé selon l'une des revendications précédentes, dans lequel le signal acoustique est défini par plusieurs paramètres choisis parmi les paramètres suivants :
fréquence moyenne ou maximale, durée du signal, temps de montée du signal, nombre de coups du signal, amplitude du signal, énergie du signal ou toute combinaison de ces paramètres.

7. Procédé selon l'une des revendications précédentes, dans lequel ledit système électrochimique est en fonctionnement.

8. Procédé selon l'une des revendications 1 à 6, dans lequel ledit système électrochimique est à l'arrêt et on détermine une réponse d'émission acoustique du système électrochimique en le sollicitant par l'envoi d'un signal électrique spécifique.

9. Système d'estimation d'un état interne d'un système électrochimique de stockage d'énergie électrique, comportant :
- des moyens de mesure d'émission acoustique dudit système électrochimique comprenant un capteur (G) et un système d'acquisition relié à audit capteur (G);
- une mémoire permettant de stocker des paramètres des signaux acoustiques caractéristiques de l'état interne dudit système électrochimique et une signature acoustique sous forme d'une relation entre une propriété relative à l'état interne dudit système électrochimique et lesdits paramètres des signaux acoustiques caractéristiques de l'état interne dudit système électrochimique, ladite relation étant préalablement calibrée au moyen de mesures pour différents états internes d'au moins un second système électrochimique d'un même type que ledit système électrochimique ;
- des moyens de détection des paramètres caractéristiques de la signature acoustique d'un état interne donné dudit premier système électrochimique ;
- des moyens pour déterminer une propriété relative à l'état interne dudit système électrochimique au moyen de ladite relation.

10. Système selon la revendication 9, dans lequel lesdits moyens de mesure d'émission acoustique comportent :
- au moins un capteur piézo-électrique en contact avec ledit système électrochimique ;
- un amplificateur permettant d'amplifier le signal acoustique ;
- un système d'acquisition permettant d'une part de filtrer les signaux acoustiques provenant de l'environnement extérieur et d'enregistrer les signaux acoustiques caractéristiques dudit système électrochimique.

11. Système selon la revendication 10 dans lequel lesdits moyens de mesure d'émission acoustique comportent plusieurs capteurs permettant de détecter un état interne de plusieurs éléments qui composent un pack ou un module de batterie.

12. Système embarqué intelligent de gestion d'une batterie comportant un système d'estimation d'un état interne de ladite batterie selon l'une des revendications 9 à 11.

13. Véhicule comportant une batterie et un système embarqué intelligent de gestion d'une batterie selon la revendication 12.

14. Système de diagnostic d'une batterie comportant un système d'estimation d'un état interne de ladite batterie selon l'une des revendications 9 à 11.

15. Système de diagnostic selon la revendication 14 comportant en outre
- un système de sollicitation en courant de ladite batterie.

## Patentansprüche

1. Verfahren zur Bewertung eines internen Zustandes eines ersten elektrochemischen Systems zur Speicherung von elektrischer Energie, wie einer Batterie, bei dem mindestens eine Eigenschaft, die sich auf den internen Zustand des ersten elektrochemischen Systems bezieht, aus akustischen Emissionsmessungen bewertet wird, umfassend die folgenden Schritte:
- für verschiedene interne Zustände mindestens eines zweiten elektrochemischen Systems eines selben Typs wie das erste elektrochemische System: - Messen einer akustischen Emissionsantwort des zweiten elektrochemischen Systems entsprechend jedem internen Zustand, und - für jede Antwort Aufzeichnen eines charakteristischen Signals für die akustische Emissionsantwort des zweiten Systems;
- Durchführen einer Verarbeitung der aufgezeichneten charakteristischen Signale des zweiten Systems, wobei sie nach Signalpopulationen mit gemeinsamen Parametern zusammengefasst werden;
- Bestimmen einer akustischen Signatur eines gegebenen internen Zustandes, wobei eine Relation zwischen mindestens einem gemeinsamen Parameter mindestens einer akustischen Signalpopulation und einem gegebenen Zustand des zweiten Systems mit Hilfe einer Analyse der Werte eines oder mehrerer gemeinsamer Parameter der akustischen Signalpopulationen, die für jeden der internen Zustände erhalten werden, kalibriert wird;
- Bestimmen einer akustischen Emissionsantwort des ersten elektrochemischen Systems, um mindestens ein charakteristisches Signal für die akustische Emissionsantwort des ersten Systems zu erhalten;
- Bewerten des internen Zustandes des elektrochemischen Systems mit Hilfe der Relation, wobei der oder die charakteristische(n) Parameter der akustischen Signatur eines gegebenen internen Zustandes in dem charakteristischen Signal der akustischen Emissionsantwort des ersten Systems erfasst werden.

2. Verfahren nach Anspruch 1, bei dem:
- ein System entwickelt wird, das es ermöglicht, direkt den oder die charakteristischen Parameter der akustischen Signatur eines gegebenen internen Zustandes zu erfassen, wobei das System umfasst:
* einen akustischen Emissionsfühler und ein System zur Erfassung der akustischen Emission, um eine akustische Emissionsantwort des ersten elektrochemischen Systems zu bestimmen und mindestens ein charakteristisches Signal der Antwort zu erhalten; und
* eine Vorrichtung zur Identifikation des oder der charakteristischen Parameter(s) einer Signalpopulation, die bei der Verarbeitung der Signale des zweiten elektrochemischen Systems identifiziert wurde, um die akustische Signatur eines gegebenen internen Zustandes in dem charakteristischen Signal der akustischen Sendeantwort des ersten elektrochemischen Systems zu erfassen.

3. Verfahren nach Anspruch 1 oder 2, bei dem die verschiedenen internen Zustände erhalten werden, indem eine beschleunigte Alterung eines zweiten elektrochemischen Systems zur Speicherung von elektrischer Energie eines selben Typs wie das erste elektrochemische System durchgeführt wird.

4. Verfahren nach Anspruch 1 bis 3, bei dem die verschiedenen internen Zustände erhalten werden, indem eine Gesamtheit von zweiten elektrochemischen Systemen desselben Typs wie das erste elektrochemische System ausgewählt wird, wobei die Systeme der Gesamtheit unterschiedliche interne Zustände haben.

5. Verfahren nach einem der vorhergehenden Ansprüche, bei dem mindestens eine der folgenden Eigenschaften in Zusammenhang mit dem internen Zustand des elektrochemischen Systems berechnet wird: ein Ladezustand (SoC) des Systems, ein Gesundheitszustand (SoH) des Systems, ein Fehlerzustand des Systems.

6. Verfahren nach einem der vorhergehenden Ansprüche, bei dem das akustische Signal durch mehrere Parameter definiert ist, die unter den folgenden Parametern ausgewählt werden: mittlere oder maximale Frequenz, Dauer des Signals, Anstiegszeit des Signals, Schlaganzahl des Signals, Amplitude des Signals, Energie des Signals oder jegliche Kombination dieser Parameter.

7. Verfahren nach einem der vorhergehenden Ansprüche, bei dem das elektrochemische System in Funktion ist.

8. Verfahren nach einem der Ansprüche 1 bis 6, bei dem das elektrochemische System außer Betrieb ist, und eine akustische Emissionsantwort des elektrochemischen Systems bestimmt wird, wobei es durch Senden eines spezifischen elektrischen Signals gefordert wird.

9. System zur Bewertung eines internen Zustandes eines elektrischen Systems zur Speicherung von elektrischer Energie, umfassend:
- Mittel zum Messen einer akustischen Emission des elektrochemischen Signals, umfassend einen Fühler (G) und ein Erfassungssystem, das mit dem Fühler (G) verbunden ist;
- einen Speicher, der es ermöglicht, Parameter der charakteristischen akustischen Signale des internen Zustandes des elektrochemischen Systems und eine akustische Signatur in Form einer Relation zwischen einer Eigenschaft in Zusammenhang mit dem internen Zustand des elektrochemischen Systems und den Parametern der charakteristischen akustischen Signale des internen Zustandes des elektrochemischen Systems zu speichern, wobei die Relation vorher mit Hilfe von Messungen für verschiedene interne Zustände mindestens eines zweiten elektrochemischen Systems eines selben Typs wie das elektrochemische System kalibriert wird;
- Mittel zur Erfassung der charakteristischen Parameter der akustischen Signatur eines gegebenen internen Zustandes des ersten elektrochemischen Systems;
- Mittel zur Bestimmung einer Eigenschaft in Zusammenhang mit dem internen Zustand des elektrochemischen Systems mit Hilfe der Relation.

10. System nach Anspruch 9, bei die Mittel zum Messen einer akustischen Emission, umfassend:
- mindestens einen piezo-elektrischen Fühler, der mit dem elektrochemischen System in Kontakt ist;
- einen Verstärker, der es ermöglicht, das akustische Signal zu verstärken;
- ein Erfassungssystem, das es einerseits ermöglicht, die akustischen Signale, die von der äußeren Umgebung kommen zu filtern, und die charakteristischen akustischen Signale des elektrochemischen Systems aufzuzeichnen.

11. System nach Anspruch 10, bei dem die Mittel zum Messen einer akustischen Emission mehrere Fühler umfassen, die es ermöglichen, einen internen Zustand von mehreren Elementen zu erfassen, aus denen ein Pack oder Modul einer Batterie besteht.

12. Eingebautes intelligentes Verwaltungssystem einer Batterie, umfassend ein System zur Bewertung eines internen Zustandes der Batterie nach einem der Ansprüche 9 bis 11.

13. Fahrzeug, umfassend eine Batterie und ein eingebautes intelligentes Verwaltungssystem einer Batterie nach Anspruch 12.

14. Diagnosesystem einer Batterie, umfassend ein System zur Bewertung eines internen Zustandes der Batterie nach einem der Ansprüche 9 bis 11.

15. Diagnosesystem nach Anspruch 14, ferner umfassend ein System zur Beaufschlagung der Batterie mit Strom.

## Claims

1. A method of estimating an internal state of a first electrochemical system for electric powder storage, such as a battery, wherein at least one property relative to the internal state of said first electrochemical system is estimated from acoustic emission measurements, comprising the hollowing stages:
- for different internal states of at least a second electrochemical system of the same type as said first electrochemical system: - measuring an acoustic emission response of said second electrochemical system corresponding to each internal state, and
- recording for each response a signal characteristic of said acoustic emission response of said second system ;
- processing the signals characteristic of said second system recorded by grouping them into populations of signals having common parameters;
- determining an acoustic signature of a given internal state by calibrating a relation between at least one of the parameters common to at least one acoustic signal population and a given internal state of said second system, by means of an analysis of the values of one or more common parameters of the acoustic signal populations obtained for each one of said internal states;
- determining an acoustic emission response of said first electrochemical system so as to obtain at least one signal characteristic of said acoustic emission response of said first system ;
- estimating the internal state of said first electrochemical system by means of said relation by detecting the parameter(s) characteristic of the acoustic signature of a given internal state, in said signal characteristic of said acoustic emission response of said first system.

2. A method as claimed in claim 1, comprising:
- developing a system allowing to directly detect the parameter(s) characteristic of the acoustic signature of a given internal state, said system including:
• an acoustic emission detector and an acoustic emission acquisition system intended to determine an acoustic emission response of the first electrochemical system and to obtain at least one signal characteristic of said response, and
• a device for identifying the parameter(s) characteristic of a signal population identified while processing the signals of the second electrochemical system intended to detect the acoustic signature of a given internal state in the signal characteristic of the acoustic emission response of the first electrochemical system.

3. A method as claimed in claim 1 or 2, wherein said different internal states are obtained through accelerated aging of a second electrochemical system for electric powder storage of the same type as said first electrochemical system.

4. A method as claimed in any one of claims 1 to 3, wherein said different internal states are obtained by selecting a set of second electrochemical systems of the same type as said first electrochemical system, said systems of said set having different internal states.

5. A method as claimed in any one of the previous claims, wherein at least one of the hollowing properties relative to the internal state of said electrochemical system is calculated: a state of charge (SoC) of said system, a state of health (SoH) of said system, a failure state of said system.

6. A method as claimed in any one of the previous claims, wherein the acoustic signal is defined by several parameters selected from among the hollowing parameters: mean or maximum frequency, signal duration, signal rise time, number of counts of the signal, signal amplitude, signal energy or any combination of these parameters.

7. A method as claimed in any one of the previous claims, wherein said electrochemical system is in operation.

8. A method as claimed in any one of claims 1 to 6, wherein said electrochemical system is off and an acoustic emission response of the electrochemical system is determined by actuating it upon sending a specific electric signal.

9. A system of estimating an internal state of an electrochemical system for electric power storage, comprising:
- means of measuring the acoustic emission of said electrochemical system comprising a detector (G) and an acquisition system connected to said detector (G) ;
- a memory allowing to store parameters of the acoustic signals characteristic of the internal state of said electrochemical system and an acoustic signature in form of a relation between a property relative to the internal state of said electrochemical system and said parameters of the acoustic signals characteristic of the internal state of said electrochemical system, said relation being first calibrated by means of measurements for different internal states of at least a second electrochemical system of the same type as said electrochemical system ;
- means for detecting parameters characteristic of the acoustic signature of a given internal state of said first electrochemical system;
- means for determining a property relative to the internal state of said electrochemical system by means of said relation.

10. A system as claimed in claim 9, wherein said acoustic emission measuring means comprise:
- at least one piezoelectric detector in contact with said electrochemical system;
- an amplifier allowing the acoustic signal to be amplified;
- an acquisition system allowing, on the one hand, to filter the acoustic signals coming from the outside environment and, on the other hand, to record the acoustic signals characteristic of said electrochemical system.

11. A system as claimed in claim 10, wherein said acoustic emission measuring means comprise several detectors allowing to detect an internal state of several elements making up a battery pack or module.

12. A smart on-board battery management system comprising a system for estimating an internal state of said battery as claimed in any one of claims 9 to 11.

13. A vehicle comprising a battery and a smart on-board battery management system as claimed in claim 12.

14. A battery diagnosis system comprising a system of estimating an internal state of said battery as claimed in any one of claims 9 to 11.

15. A diagnosis system as claimed in claim 14, further comprising:
- a system for drawing current from said battery.
